# EUROPEAN PATENT APPLICATION

(11) **EP 4 604 172 A1**
(43) Date of publication of application: **20.08.2025**
(21) Application number: 23877283.4
(22) Date of filing: 10.10.2023
(51) Int. Cl.: H01L 21/683, H02N 13/00

(54) **ADSORPTION SUBSTRATE**

(30) Priority: 11.10.2022 JP 2022163590
(71) Applicant: Kyocera Corporation, Kyoto-shi, Kyoto 612-8501 (JP)
(72) Inventor: FUJIO, Kazuhiko, Kyoto-shi, Kyoto 612-8501 (JP); ITO, Masaki, Kyoto-shi, Kyoto 612-8501 (JP)
(74) Representative: Viering, Jentschura & Partner mbB Patent- und Rechtsanwälte
(86) International application number: PCT/JP2023/036765
(87) International publication number: WO 2024/080280

(57) **Abstract**

An adsorption substrate according to the present disclosure includes a base, a conductive layer, and a protruding portion. The base has an insulating property. The base has a first surface configured to hold an article to be processed, and a second surface located on an opposite side to the first surface. The conductive layer is located inside the base. The protruding portion has conductivity. The protruding portion protrudes from the conductive layer toward the second surface. The protruding portion extends in a direction parallel to the first surface. The protruding portion has a tapered shape in which a width in a cross section orthogonal to an extending direction is reduced toward the second surface, or a rectangular shape in which the width is uniform.

## Description

### TECHNICAL FIELD

The disclosed embodiments relate to an adsorption substrate.

### BACKGROUND OF INVENTION

A known electrostatic chuck holds an article to be processed such as a semiconductor wafer. The electrostatic chuck includes an adsorption substrate. The adsorption substrate includes a base. The base has an insulating property. An electrode is provided inside the base. A mesh-shaped electrode may be adopted as the electrode to be embedded inside the base. The resistance of the mesh-shaped electrode can be reduced by appropriately selecting the thickness of the linear conductor constituting the electrode and the roughness of the mesh.

In a manufacturing process of such an adsorption substrate, a mesh-shaped conductor is placed on an upper surface of a green sheet having an insulating property. An insulating material is laminated on the upper surface of the green sheet on which the mesh-shaped conductor is placed. The green sheet on which the insulating material is laminated is pressed in the thickness direction, so that the mesh-shaped electrode is embedded in the base.

### CITATION LIST

### PATENT LITERATURE

Patent Document 1: JP 2009-141344 A

### SUMMARY

An adsorption substrate according to an aspect of an embodiment includes a base, a conductive layer, and a protruding portion. The base has an insulating property. The base has a first surface configured to hold an article to be processed, and a second surface located on an opposite side to the first surface. The conductive layer is located inside the base. The protruding portion has conductivity. The protruding portion protrudes from the conductive layer toward the second surface. The conductive layer and the protruding portion are in contact with each other. The protruding portion extends in a direction parallel to the first surface. The protruding portion has a tapered shape in which a width in a cross section orthogonal to an extending direction is reduced toward the second surface, or a rectangular shape in which the width is uniform.

### BRIEF DESCRIPTION OF THE DRAWINGS

FIG. 1 is a cross-sectional view illustrating a configuration of an electrostatic chuck having an adsorption substrate according to a first embodiment.
FIG. 2 is a cross-sectional view taken along line A-A illustrated in FIG. 1.
FIG. 3 is a cross-sectional view of an adsorption substrate according to a comparative example of the first embodiment.
FIG. 4 is an enlarged view of the inside of a broken-line rectangle illustrated in FIG. 3.
FIG. 5 is a cross-sectional view taken along line B-B illustrated in FIG. 2.
FIG. 6 is a cross-sectional view taken along line C-C illustrated in FIG. 2.
FIG. 7 is an enlarged view of the inside of a broken-line rectangle illustrated in FIG. 6.
FIG. 8 is an explanatory view illustrating a method of manufacturing the adsorption substrate according to the first embodiment.
FIG. 9 is an explanatory view illustrating the method of manufacturing the adsorption substrate according to the first embodiment.
FIG. 10 is an explanatory view illustrating the method of manufacturing the adsorption substrate according to the first embodiment.
FIG. 11 is an explanatory view illustrating the method of manufacturing the adsorption substrate according to the first embodiment.
FIG. 12 is an explanatory view illustrating the method of manufacturing the adsorption substrate according to the first embodiment.
FIG. 13 is an explanatory view illustrating the method of manufacturing the adsorption substrate according to the first embodiment.
FIG. 14 is an explanatory view of a protruding portion according to the second embodiment.
FIG. 15 is an explanatory view of a protruding portion according to a third embodiment.
FIG. 16 is an explanatory view of a protruding portion according to a fourth embodiment.

### DESCRIPTION OF EMBODIMENTS

Embodiments of an adsorption substrate disclosed in the present application will now be described with reference to the accompanying drawings. Note that the disclosure is not limited by the following embodiments. The embodiments described below can be combined as appropriate as long as the processing contents do not contradict each other. In the following embodiments, components having the same function are denoted by the same reference numerals, and redundant description will be omitted.

In the following embodiments, expressions such as "constant", "orthogonal", "perpendicular", and "parallel" may be used, but these expressions need not mean exactly "constant", "orthogonal", "perpendicular", and "parallel". That is, each of the expressions described above allows for deviations in, for example, manufacturing accuracy, installation accuracy, and the like.

In each of the drawings, which will be referred to below, for ease of explanation, an X axis direction, a Y axis direction, and a Z axis direction that are orthogonal to each other may be defined to illustrate a rectangular coordinate system in which a Z axis positive direction is a vertically upward direction.

Conventionally, an electrode used in an electrostatic chuck that holds an article to be processed such as a semiconductor wafer has room for improvement in terms of resistance to thermal stress generated when a current flows or physical stress generated when a load is applied. Therefore, it is expected to provide an adsorption substrate including an electrode having improved resistance to thermal stress and physical stress.

### 1. Configuration of Electrostatic Chuck According to First Embodiment

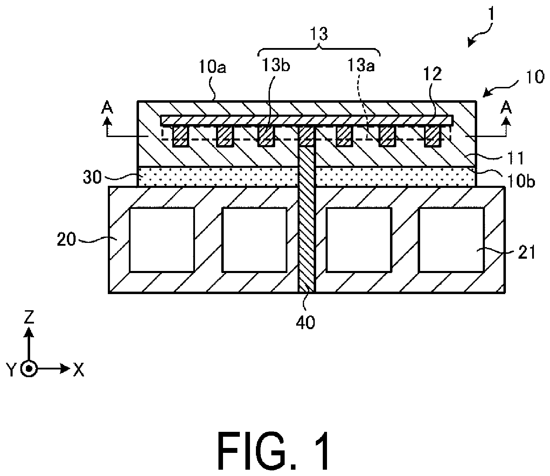

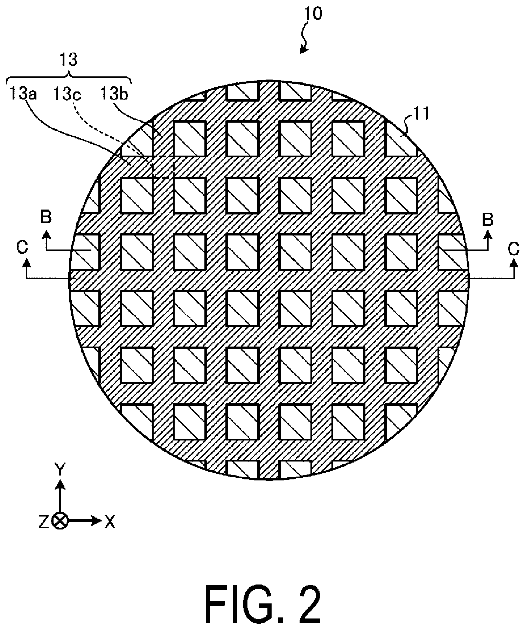

First, a configuration of an electrostatic chuck having an adsorption substrate according to a first embodiment will be described with reference to FIGs. 1 and 2. FIG. 1 is a cross-sectional view illustrating a configuration of an electrostatic chuck having an adsorption substrate according to a first embodiment. FIG. 2 is a cross-sectional view taken along line A-A illustrated in FIG. 1.

As illustrated in FIG. 1, the electrostatic chuck 1 may include an adsorption substrate 10, a heat exchanger 20, and a bonding material 30. The electrostatic chuck 1 adsorbs an article to be processed, such as a semiconductor wafer, by using an electrostatic force generated on the surface of the adsorption substrate 10.

The adsorption substrate 10 may be substantially disk shaped, for example. The adsorption substrate 10 may have a disk shape having a diameter of from 50 mm to 400 mm and a thickness of from 2 mm to 15 mm, for example. The adsorption substrate 10 may have a first surface 10a and a second surface 10b facing each other in the thickness direction. The first surface 10a may be a holding surface that holds the article to be processed. The second surface 10b may be located on the opposite side of the first surface 10a, and may be bonded to the heat exchanger 20 using the bonding material 30.

The adsorption substrate 10 may include a base 11, a conductive layer 12, and a protruding portion 13. The base 11 may have an insulating property. The base 11 may contain, for example, a ceramic such as aluminum oxide (Al₂O₃), aluminum nitride (AlN), or yttria (Y₂O₃) as a main component.

The conductive layer 12 may be located inside the base 11. The conductive layer 12 may extend along the first surface 10a in the vicinity of the first surface 10a. The conductive layer 12 may have, for example, a substantially circular shape in a plan view when the base 11 is viewed in a perspective plan view toward the first surface 10a. The diameter of the conductive layer 12 in a plan view may be, for example, 30 mm to 398 mm.

The conductive layer 12 may contain, for example, a noble metal such as platinum (Pt) or palladium (Pd) as a main component. In such a case, firing can be performed even in an atmosphere containing oxygen. The conductive layer 12 may contain tungsten (W) or molybdenum (Mo) as a main component. Note that in the present disclosure, a case of a unipolar structure having one conductive layer 12 is illustrated, but the number of conductive layers 12 is not limited to one, and a bipolar structure having two conductive layers 12 may be used.

The protruding portion 13 may be located inside the base 11. The protruding portion 13 may be located so as to protrude from the conductive layer 12 toward the second surface 10b side. The conductive layer 12 and the protruding portion 13 may be in contact with each other. The protruding portion 13 may extend in a direction parallel to the first surface 10a. For example, as illustrated in FIG. 2, the protruding portion 13 may extend in a direction parallel to the first surface 10a so as to form a mesh shape in a perspective plan view of the base 11 as viewed toward the first surface 10a.

To be specific, the protruding portion 13 may include a plurality of first linear portions 13a, a plurality of second linear portions 13b, and a plurality of intersecting portions 13c. The first linear portion 13a extends in the first direction in a perspective plan view of the base 11 as viewed toward the first surface 10a. The first direction may be, for example, a direction parallel to the X-axis illustrated in FIG. 2.

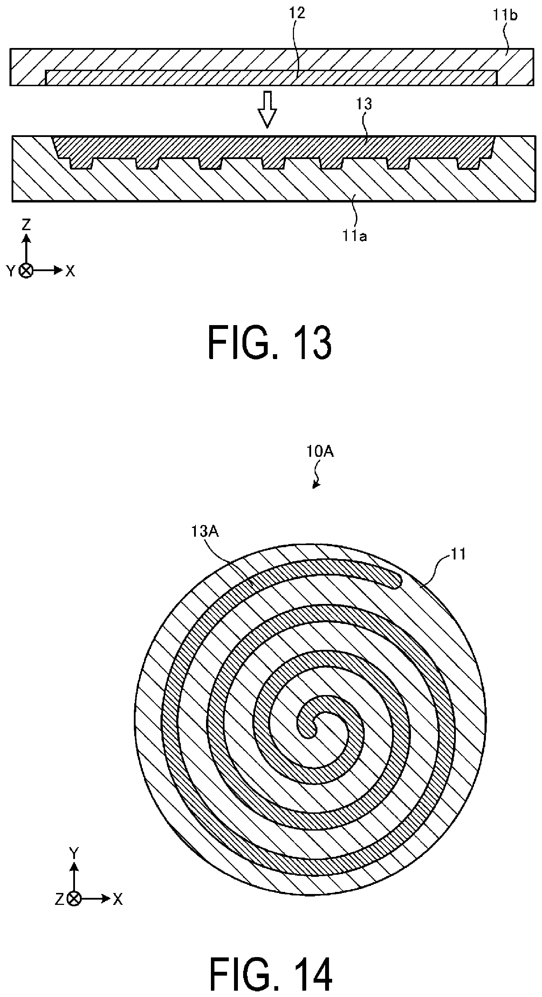

The second linear portion 13b may extend in a second direction intersecting the first direction in a perspective plan view of the base 11 as viewed toward the first surface 10a. The second direction may be, for example, a direction parallel to the Y-axis illustrated in FIG. 2. The intersecting portion 13c may be a portion where the first linear portion 13a and the second linear portion 13b cross each other. Note that the shape of the protruding portion 13 in a perspective plan view when viewed toward the first surface 10a portion is not limited to the mesh shape. Variations of the shape of the protruding portion 13 in a perspective plan view as viewed toward the first surface 10a will be described later with reference to FIGs. 14 to 16.

As illustrated in FIG. 1, since the protruding portion 13 is located so as to fit into the recessed portion of the base 11, for example, even in a case where the adsorption substrate 10 receives an external force, the protruding portion 13 is less likely to be detached from the base 11, and thus the conductive layer 12 connected to the protruding portion 13 is less likely to be peeled off from the base 11. Accordingly, delamination is less likely to occur in the adsorption substrate 10 according to the first embodiment.

The material of the protruding portion 13 may be, for example, the same as that of the conductive layer 12. This makes it possible to produce the adsorption substrate 10 without separately preparing the material of the protruding portion 13.

The material of the protruding portion 13 may be different from that of the conductive layer 12. The conductive layer 12 may be connected to a power supply terminal 40 drawn out to the outside. Power may be supplied to the conductive layer 12 and the protruding portion 13 via the power supply terminal 40. The conductive layer 12 may be connected to the power supply terminal 40 drawn to the outside via the protruding portion 13. The protruding portion 13 may be made of, for example, a metal material or a carbon material. Note that the conductive layer 12 and the protruding portion 13 may be used as, for example, a heater or a high-frequency electrode.

The heat exchanger 20 may receive heat of the adsorption substrate 10 and dissipate the heat to the outside. The heat exchanger 20 may be bonded to the second surface 10b of the adsorption substrate 10 by the bonding material 30 such as silicone. The heat exchanger 20 may include a flow path 21 through which a cooling medium flows. The heat exchanger 20 according to the first embodiment may be made of metal such as aluminum, or may be made of ceramic such as alumina or silicon carbide.

Note that when the heat exchanger 20 is made of a metal, the heat exchanger 20 may be used as the high-frequency electrode of the adsorption substrate 10. When the heat exchanger 20 is made of ceramic, a metal layer may be formed on the outer surface of the heat exchanger 20, and the metal layer may be used as the high frequency electrode of the electrostatic chuck 1.

### 2. Adsorption Substrate According to Comparative Example

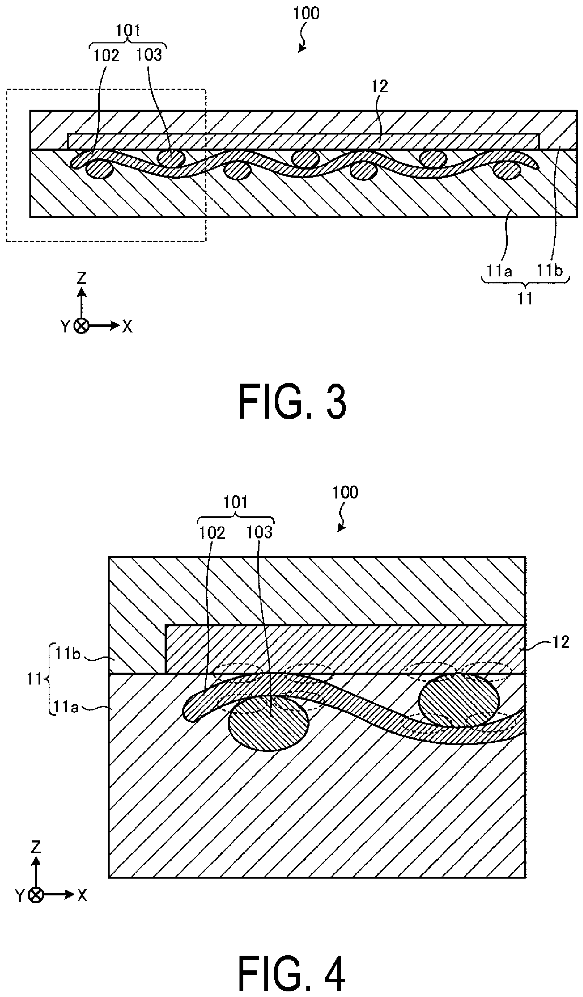

Here, an adsorption substrate 100 according to a comparative example of the first embodiment will be described with reference to FIGs. 3 and 4. FIG. 3 is a cross-sectional view of an adsorption substrate according to a comparative example of the first embodiment. FIG. 4 is an enlarged view of the inside of a broken-line rectangle illustrated in FIG. 3.

A general adsorption substrate including a conductive layer therein and a mesh-shaped electrode electrically connected to the conductive layer is manufactured by, for example, embedding the mesh-shaped electrode formed of a conductor line and the conductive layer in an insulating substrate in advance.

In the mesh-shaped electrode, the plurality of first conductor lines is disposed parallel to the first direction at equal intervals. A plurality of second conductor lines is formed on the mesh-shaped electrode so as to be disposed in parallel to a second direction intersecting the first direction at equal intervals.

When the mesh-shaped electrodes formed in this manner are adopted, as illustrated in FIG. 3, the adsorption substrate 100 according to the comparative example is manufactured by bonding a first base 11a having an insulating property in which the mesh-shaped electrode 101 is embedded and a second base 11b having an insulating property in which the conductive layer 12 is embedded. Thereafter, the adsorption substrate 100 is pressed in the thickness direction.

Accordingly, in the adsorption substrate 100, the mesh-shaped electrode 101 and the conductive layer 12 are electrically connected to each other. In the adsorption substrate 100, gaps between the conductive layer 12, the first conductor line 102, and the second conductor line 103 are filled with the insulating material of the base 11. However, the adsorption substrate 100 according to the comparative example has room for improvement in resistance to thermal stress and physical stress.

In general, the first conductor line 102 and the second conductor line 103 have an elongated cylindrical shape. Therefore, in the mesh-shaped electrode formed in advance, the contact area between the first conductor line 102 and the second conductor line 103 is narrower than the line width of the first conductor line 102 and the second conductor line 103.

Therefore, as illustrated in FIG. 4, the insulating material entering the gap has an acute angle in a cross-sectional view around the connection portion between the first conductor line 102 and the second conductor line 103, around the connection portion between the first conductor line 102 and the conductive layer 12, and around the connection portion between the second conductor line 103 and the conductive layer 12.

As a result, a region indicated by an ellipse of a broken line in FIG. 4 becomes a place where a thermal stress when a current flows and a physical stress when a load is applied to a product are concentrated, which may cause product destruction. Therefore, the adsorption substrate 10 according to the first embodiment may include an electrode having improved resistance to thermal stress and physical stress.

### 3. Configuration of Adsorption Substrate According to First Embodiment

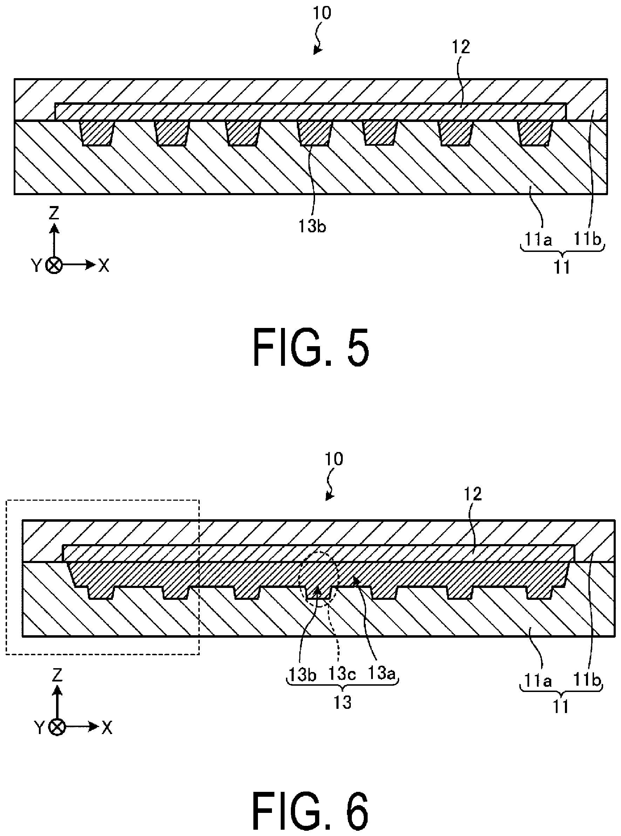

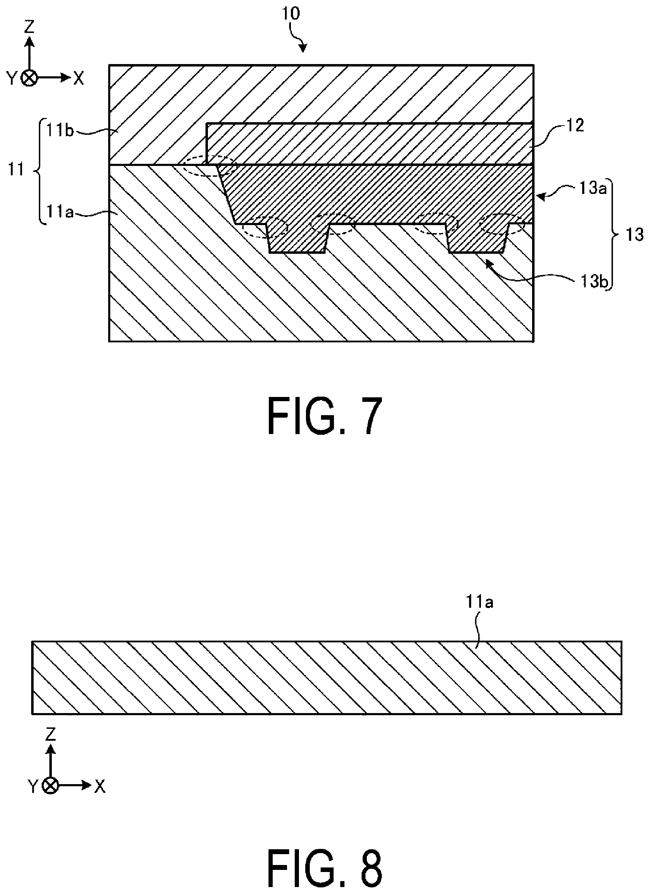

A configuration of the adsorption substrate 10 according to the first embodiment will be described with reference to FIGs. 5 to 7. FIG. 5 is a cross-sectional view taken along line B-B illustrated in FIG. 2. FIG. 6 is a cross-sectional view taken along line C-C illustrated in FIG. 2. FIG. 7 is an enlarged view of the inside of a broken-line rectangle illustrated in FIG. 6.

As illustrated in FIG. 6, the second linear portion 13b of the protruding portion 13 of the adsorption substrate 10 may have a tapered shape in which the width in the cross section orthogonal to the extending direction parallel to the first surface 10a illustrated in FIG. 1 is reduced toward the second surface 10b illustrated in FIG. 1. The second linear portion 13b may have a rectangular shape in which the width in the cross section orthogonal to the extending direction parallel to the first surface 10a illustrated in FIG. 1 is uniform.

As illustrated in FIG. 7, the first linear portion 13a in the protruding portion 13 of the adsorption substrate 10 may have a tapered shape in which the width in the cross section orthogonal to the extending direction parallel to the first surface 10a illustrated in FIG. 1 is reduced toward the second surface 10b illustrated in FIG. 1. The first linear portion 13a may have a rectangular shape having a uniform width in a cross section orthogonal to an extending direction parallel to the first surface 10a illustrated in FIG. 1.

Therefore, as illustrated in FIG. 7, around the connecting portion between the first linear portion 13a and the second linear portion 13b and around the connecting portion between the conductive layer 12 and the first linear portion 13a, the insulating material entering the gap has a right angle or an obtuse angle in a cross-sectional view, and does not have an acute angle.

As a result, in the region indicated by the ellipse of the broken line in FIG. 7, the thermal stress when the current flows and the physical stress when the load is applied to the product are less likely to be concentrated as compared with the adsorption substrate 100 according to the comparative example. Therefore, the adsorption substrate 10 can improve resistance to thermal stress and physical stress.

As illustrated in FIG. 6, the length of the intersecting portion 13c between the first linear portion 13a and the second linear portion 13b in the protruding direction of the protruding portion 13 may be greater than the length of the first linear portion 13a and the second linear portion 13b in the protruding direction of the protruding portion 13.

That is, the surface of the protruding portion 13 on the second surface 10b side illustrated in FIG. 1 may be an uneven surface instead of a flat surface. Accordingly, in the adsorption substrate 10, since the contact surface between the protruding portion 13 and the first base 11a increases as compared with a case where the surface of the protruding portion 13 on the second surface 10b side illustrated in FIG. 1 is a flat surface, delamination is less likely to occur in the first base 11a.

### 4. Manufacturing Method of Adsorption Substrate According to First Embodiment

A method of manufacturing the adsorption substrate 10 according to the first embodiment will be described with reference to FIGs. 8 to 13. FIGs. 8 to 13 are explanatory diagrams illustrating the method of manufacturing the adsorption substrate according to the first embodiment.

In the case of manufacturing the adsorption substrate 10, first, as illustrated in FIG. 8, a first base 11a may be prepared. The first base 11a may be a so-called green sheet before being fired. The first base 11a may be molded to have a circular shape in a plan view.

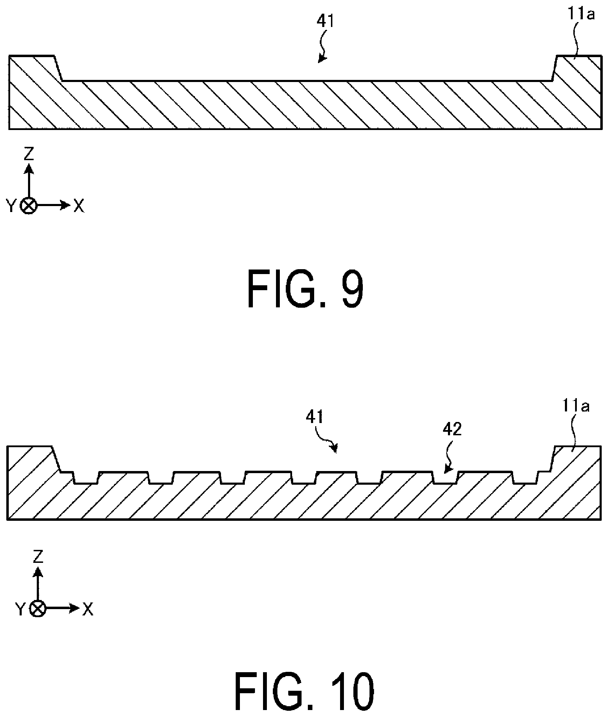

Subsequently, as illustrated in FIG. 9, a first groove 41 extending in the first direction may be formed at the formation position of the first linear portion 13a on one main surface of the first base 11a. For example, the first groove 41 may be formed so as to extend in a direction parallel to the X-axis direction on the upper surface of the first base 11a. The first groove 41 may be formed by, for example, a laser. The first groove 41 may be formed by a mold.

Thereafter, as illustrated in FIG. 10, a second groove 42 extending in the second direction intersecting the first direction may be formed at the formation position of the second linear portion 13b on the one main surface of the first base 11a. For example, the second groove 42 may be formed so as to extend in a direction parallel to the Y-axis direction on the upper surface of the first base 11a. The second groove 42 may be formed by a mold. The second groove 42 may be formed by, for example, a laser. As a result, the depth of the second groove at the intersecting portion of the first groove 41 and the second groove 42 is greater than the depth of the first groove 41. Note that the first groove 41 and the second groove 42 may be formed by stacking green sheets punched into these shapes.

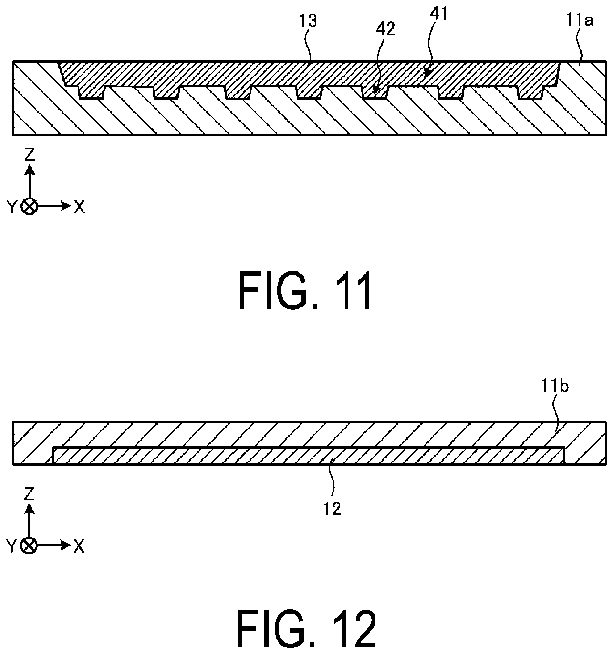

Subsequently, as illustrated in FIG. 11, the protruding portion 13 may be formed by filling the first groove 41 and the second groove 42 with a paste-like conductive material. The filling with the conductive material may be performed by, for example, screen printing.

Thereafter, as illustrated in FIG. 12, the second base 11b may be prepared, and the conductive layer 12 may be embedded in one main surface of the second base 11b. For example, the conductive layer 12 may be embedded in the lower surface of the second base 11b. The conductive layer 12 may be formed by filling a conductive material in a recessed portion formed on the lower surface of the second base 11b by the screen printing.

Alternatively, a first green sheet may be prepared by applying a paste-like conductive material, which will become the conductive layer 12 later, to the surface of a green sheet. A second green sheet may be prepared by applying, to the surface of the green sheet, a paste-like conductive material that will later become the protruding portion 13. The first and second green sheets may be laminated so that the conductive materials face each other.

The second base 11b may be a paste-like sheet containing ceramic as a main component. The second base 11b may be a so-called green sheet before sintering. The second base 11b may be molded to have a circular shape in a plan view.

Subsequently, as illustrated in FIG. 13, the first base 11a and the second base 11b may be disposed to face each other such that the conductive layer 12 and the protruding portion 13 face each other. Thereafter, the first base 11a and the second base 11b may be bonded to each other. Finally, the first base 11a and the second base 11b are pressed in the thickness direction and sintered in a sinter oven to complete the adsorption substrate 10.

### 5. Shape of Protruding Portion According to Second to Fourth Embodiments

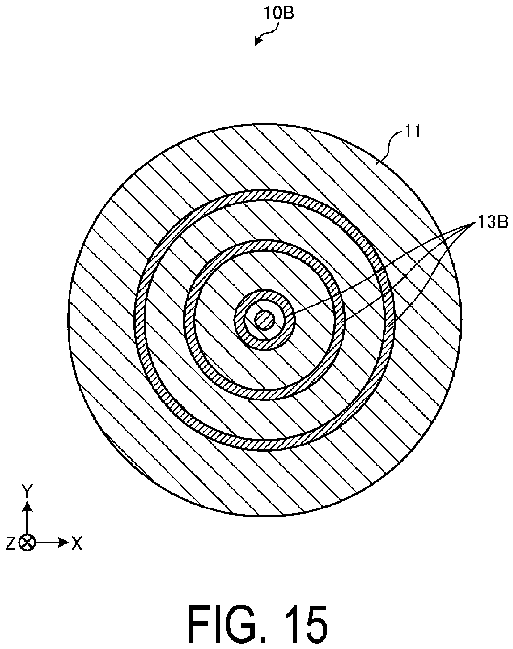

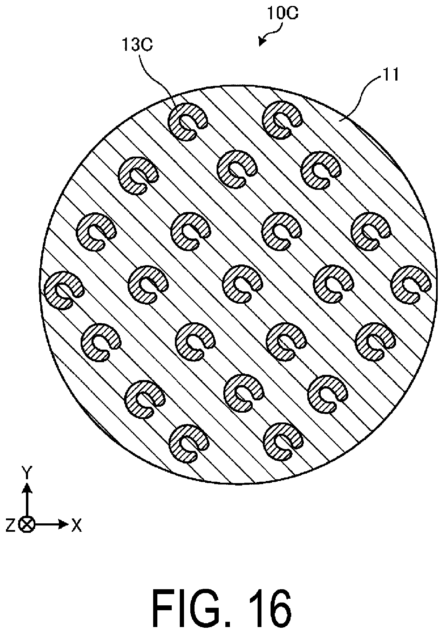

The shapes of the protruding portions according to second to fourth embodiments will be described with reference to FIGs. 14 to 16. FIG. 14 is an explanatory diagram of a protruding portion according to the second embodiment. FIG. 15 is an explanatory diagram of a protruding portion according to the third embodiment. FIG. 16 is an explanatory diagram of a protruding portion according to a fourth embodiment. Although the case where the protruding portion 13 has a mesh shape in a perspective plan view of the base 11 as viewed toward the first surface 10a has been described above, the shape of the protruding portion 13 can be modified in various ways. Note that in the second to fourth embodiments illustrated in FIGs. 14 to 16, the cross section orthogonal to the extending direction of the protruding portion 13 is obtained at any position.

For example, as illustrated in FIG. 14, a protruding portion 13A of an adsorption substrate 10A according to the second embodiment may have a spiral shape in a perspective plan view in which the base 11 is viewed toward the first surface 10a. The cross-sectional shape of the protruding portion 13A orthogonal to the extending direction parallel to the first surface 10a illustrated in FIG. 1 may be, for example, the same as and/or similar to the cross-sectional shape of the first linear portion 13a or the second linear portion 13b in the protruding portion 13.

Accordingly, the resistance of the adsorption substrate 10A can be easily reduced by appropriately selecting the length of the spiral protruding portion 13A in the extending direction and the area of the cross section orthogonal to the extending direction.

As illustrated in FIG. 15, an adsorption substrate 10B according to the third embodiment may have a plurality of protruding portions 13B. In this case, the protruding portion 13B may have a circular ring shape in a perspective plan view of the base 11 as viewed toward the first surface 10a.

The protruding portion 13B may be disposed concentrically with another protruding portion 13B. The cross-sectional shape of the protruding portion 13B orthogonal to the extending direction parallel to the first surface 10a illustrated in FIG. 1 may be, for example, the same as and/or similar to the cross-sectional shape of the first linear portion 13a or the second linear portion 13b in the protruding portion 13.

Accordingly, the resistance of the adsorption substrate 10B can be easily reduced by appropriately selecting the thickness and the radius of the circular ring of the protruding portion 13B having the circular ring shape.

As illustrated in FIG. 16, an adsorption substrate 10C according to the fourth embodiment may have a plurality of protruding portions 13C. In this case, the protruding portion 13C may have a C-shape in a perspective plan view of the base 11 as viewed toward the first surface 10a.

The cross-sectional shape of the protruding portion 13C orthogonal to the extending direction parallel to the first surface 10a illustrated in FIG. 1 may be, for example, the same as and/or similar to the cross-sectional shape of the first linear portion 13a or the second linear portion 13b in the protruding portion 13.

Accordingly, the resistance of the adsorption substrate 10C can be easily reduced by appropriately selecting the number of C-shaped portions of the C-shaped protruding portion 13C and the thickness of the C-shaped portion.

### REFERENCE SIGNS

1 Electrostatic chuck
10 Adsorption substrate
10a First surface
10b Second surface
10A, 10B, 10C Adsorption substrate
11 Base
11a First base
11b Second base
12 Conductive layer
13, 13A, 13B, 13C Protruding portion
13a First linear portion
13b Second linear portion
13c Intersecting portion
20 Heat exchanger
21 Flow path
30 Bonding material
40 Power supply terminal
100 Adsorption substrate
101 Electrode
102 First conductor line
103 Second conductor line

## Claims

1. An adsorption substrate comprising:
a base;
a conductive layer; and
a protruding portion, wherein
the base has an insulating property, and has a first surface configured to hold an article to be processed and a second surface located on an opposite side to the first surface,
the conductive layer is located inside the base, and
the protruding portion has conductivity, protrudes from the conductive layer toward the second surface, extends in a direction parallel to the first surface, and has a tapered shape in which a width in a cross section orthogonal to an extending direction is reduced toward the second surface, or a rectangular shape in which the width is uniform.

2. The adsorption substrate according to claim 1, wherein
in a perspective plan view of the base as viewed toward the first surface, the protruding portion has a mesh shape.

3. The adsorption substrate according to claim 2, wherein
in a perspective plan view of the base as viewed toward the first surface, the protruding portion comprises a plurality of first linear portions extending in a first direction, a plurality of second linear portions extending in a second direction intersecting the first direction, and a plurality of intersecting portions where the plurality of first linear portions and the plurality of second linear portions intersect each other, and
a length of the plurality of intersecting portions in a protruding direction of the protruding portion is greater than a length of the plurality of first linear portions and the plurality of second linear portions in the protruding direction of the protruding portion.

4. The adsorption substrate according to claim 1, wherein
in a perspective plan view of the base as viewed toward the first surface, the protruding portion has a spiral shape.

5. The adsorption substrate according to claim 1, comprising a plurality of the protruding portions, wherein
in a perspective plan view of the base as viewed toward the first surface, each of the protruding portions has a circular shape and is disposed concentrically with other protruding portions of the protruding portions.

6. The adsorption substrate according to claim 1, comprising a plurality of the protruding portions, wherein
in a perspective plan view of the base as viewed toward the first surface, each of the protruding portions has a C-shape.
